# EUROPEAN PATENT SPECIFICATION

(11) **EP 3 661 274 B1**
(45) Date of publication and mention of the grant of the patent: **05.04.2023**
(21) Application number: 17921084.4
(22) Date of filing: 09.08.2017
(51) Int. Cl.: H04W 52/52, H04W 8/22, G06F 1/20, H04W 8/24, H04W 24/02

(54) **OVERHEATING PROTECTION METHOD AND DEVICE OF USER EQUIPMENT, USER EQUIPMENT AND BASE STATION**
ÜBERHITZUNGSSCHUTZVERFAHREN UND -VORRICHTUNG FÜR BENUTZERGERÄT, BENUTZERGERÄT UND BASISSTATION
DISPOSITIF ET PROCÉDÉ DE PROTECTION CONTRE LA SURCHAUFFE D'UN ÉQUIPEMENT UTILISATEUR, ÉQUIPEMENT UTILISATEUR ET STATION DE BASE

(43) Date of publication of application: 03.06.2020
(73) Proprietor: Beijing Xiaomi Mobile Software Co., Ltd., Beijing 100085 (CN)
(72) Inventor: HONG, Wei, Beijing 100085 (CN)
(74) Representative: Gevers Patents
(86) International application number: PCT/CN2017/096673
(87) International publication number: WO 2019/028711

(56) References cited:
- CN-A- 101 868 021
- CN-A- 102 025 533
- CN-A- 102 176 782
- CN-A- 104 317 373
- US-A1- 2002 087 907
- US-A1- 2009 290 625
- US-A1- 2010 273 517
- US-A1- 2015 137 618
- US-A1- 2017 164 220

## Description

### TECHNICAL FIELD

Embodiments of the present disclosure relates to the field of wireless communication, and in particular to a method for implementing User Equipment (UE) overheating protection, UE, and a base station.

### BACKGROUND

In a Long Term Evolution (LTE) system, a mode of wireless transmission such as high-order Multiple-Input Multiple-Output (MIMO), multi-carrier aggregation, high-order modulation decoding, etc., may be set for UE to meet a demand of a user for high-speed data transmission. However, such a mode of high-speed wireless transmission may cause UE to be overheated. Overheating of UE may further cause interruption of transmission of service data of the UE, and even restart of the UE, etc.

In related art, to ensure good experience of a user when using UE, a UE provider may generally control a temperature of a mobile phone, such as by lowering a radio link configuration by detachment and re-attachment of UE, to avoid an overheating condition of the UE. In related art, detachment and re-attachment of UE may interrupt transmission of service data, which lowers use experience of a user.

US20170164220 A1 discloses that a thermal finite-state-automaton includes system states and transitions between the system states. The system states may be based on a combination of network parameters for communicating through the wireless communication system and UE processing parameters. A default state is for operation of the UE at a sustainable performance configuration level for the network parameters and the UE processing parameters to maintain a UE temperature below a first temperature threshold. A high state is for operation of the UE during up to a maximum time duration at a peak performance configuration level for the network parameters and the UE processing parameters. A recovery state is for operation of the UE during at least a minimum time duration at a reduced performance configuration level for the network parameters and the UE processing parameters. An emergency shutdown state is triggerable by the UE temperature exceeding a second temperature threshold.

US20090290625 A1 discloses a data module operable in a wireless communication system. The data module comprises a plurality of circuit components, one or more temperature sensors, and a thermal management unit. The temperature sensors are configured to determine the temperature of a corresponding circuit component. The thermal management unit is configured to determine one or more thermal characteristics of the data module based on the temperature determinations, and to generate one or more power control point signals indicating whether to adjust corresponding operating characteristics of a target component based on the determined thermal characteristics.

US20100273517 A1 discloses controlling component temperature in a wireless transmit receive unit (WTRU) and thereby preventing the component from reaching an undesirable temperature. A method and an apparatus are provided for reducing a value of a maximum allowed transmit power to adjust a data rate. The WTRU adjusts the value of the maximum allowed transmit power resulting in an adjustment to the temperature of the component.

US20150137618 A1 discloses adaptive battery protection. A method includes disabling a timer, when a current drawn by a battery-powered device from a battery is less than or equal to a lower current threshold. When the timer is disabled, the battery may remain connected to the battery-powered device. The method further includes enabling the timer when the current drawn from the battery is greater than the lower current threshold and less than an extended current threshold. When the timer is enabled, the timer may allow the battery to remain connected to the battery-powered device until the timer expires. The method further includes disconnecting the battery when the timer expires or when the current drawn from the battery exceeds the extended current threshold.

US20020087907 A1 discloses that a sytem for recovering from an overheated processor includes a processor that asserts a thermal trip signal when the internal temperature of the processor exceeds a maximum acceptable limit. A power management device asserts a power off signal to a voltage regulator module in response to the assertion of the thermal trip signal by the processor. The voltage regulator module removes power from the processor in response to the assertion of the power off signal by the power management device.

### SUMMARY

Embodiments of the present disclosure provide a UE overheating protection method and device, UE, and a base station, capable of cooling overheated UE by sending, to a base station, signaling to request a cooling configuration without interrupting transmission of service data, and avoiding a burden of frequent signaling at an arbitrary time by performing an overheating protection operation a preset period after first signaling is sent as determined using a timer.

The features of the method and device are defined in the independent claims, and the preferable features are defined in the dependent claims. The following aspects are provided for illustrative purposes.

According to a first aspect of embodiments of the present disclosure, a User Equipment (UE) overheating protection method applies to UE. The method includes:
in response to determining that the UE is experiencing an overheating condition due to an overhigh radio link configuration, sending, to a base station, first signaling to request a cooling configuration, and starting a timer of a preset timing period;
detecting a temperature of the UE at expiration of the timer; and
performing an operation corresponding to a result of the detection.

In an embodiment, the detecting a temperature of the UE at expiration of the timer may include:
resetting the timer in response to receiving, before expiration of the timer, response signaling, wherein the response signaling is fed back by the base station based on the first signaling and contains the cooling configuration; and
after the timer is reset, detecting the temperature of the UE at expiration of the timer.

In an embodiment, the performing an operation corresponding to a result of the detection may include:
in response to the result of the detection being that the UE is still experiencing the overheating condition at expiration of the timer, sending, to the base station, second signaling to request the cooling configuration, and restarting the timer.

In an embodiment, the performing an operation corresponding to a result of the detection may include:
in response to the result of the detection being that the UE no longer experiences the overheating condition at expiration of the timer, sending, to the base station, third signaling indicating that the UE no longer experiences the overheating condition, and stopping the timer; or
sending no signaling to the base station, and stopping the timer.

In an embodiment, the method may further include:
in response to occurrence of a connection reestablishment procedure before expiration of the timer, stopping the timer.

According to a second aspect of embodiments of the present disclosure, a User Equipment (UE) overheating protection method includes:
receiving first signaling sent by LTE to request a cooling configuration;
generating response signaling containing the cooling configuration based on the first signaling; and
sending the response signaling.

In an embodiment, the generating response signaling containing the cooling configuration based on the first signaling may include:
acquiring assistance information that facilitates cooling by parsing the first signaling; and
generating the response signaling based on the assistance information that facilitates cooling.

According to a third aspect of embodiments of the present disclosure, a User Equipment (UE) overheating protection device applies to UE. The device includes an overheating handling module, a detecting module, and a performing module.

The overheating handling module is adapted to, in response to determining that the UE is experiencing an overheating condition due to an overhigh radio link configuration, sending, to a base station, first signaling to request a cooling configuration, and starting a timer of a preset timing period.

The detecting module is adapted to detecting a temperature of the UE at expiration of the timer.

The performing module is adapted to performing an operation corresponding to a result of the detection.

In an embodiment, the detecting module may include a resetting sub-module and a detecting sub-module.

The resetting sub-module may be adapted to resetting the timer in response to receiving, before expiration of the timer, response signaling, wherein the response signaling is fed back by the base station based on the first signaling and contains the cooling configuration.

The detecting sub-module may be adapted to, after the timer is reset, detecting the temperature of the UE at expiration of the timer.

In an embodiment, the performing module may include a first processing sub-module.

The first processing sub-module may be adapted to, in response to the result of the detection being that the UE is still experiencing the overheating condition at expiration of the timer, sending, to the base station, second signaling to request the cooling configuration, and restarting the timer.

The performing module may include a second processing sub-module or a third processing sub-module.

The second processing sub-module may be adapted to, in response to the result of the detection being that the UE no longer experiences the overheating condition at expiration of the timer, sending, to the base station, third signaling indicating that the UE no longer experiences the overheating condition, and stopping the timer.

The third processing sub-module may be adapted to sending no signaling to the base station, and stopping the timer.

In an embodiment, the device may further include a timer stopping module.

The timer stopping module may be adapted to, in response to occurrence of a connection reestablishment procedure before expiration of the timer, stopping the timer.

According to a fourth aspect of embodiments of the present disclosure, a User Equipment (UE) overheating protection device includes a receiving module, a generating module, and a sending module.

The receiving module is adapted to receiving first signaling sent by UE to request a cooling configuration.

The generating module is adapted to generating response signaling containing the cooling configuration based on the first signaling.

The sending module is adapted to sending the response signaling.

In an embodiment, the generating module may include a parsing sub-module and a generating sub-module.

The parsing sub-module may be adapted to acquiring assistance information that facilitates cooling by parsing the first signaling.

The generating sub-module may be adapted to generating the response signaling based on the assistance information that facilitates cooling.

According to a fifth aspect of embodiments of the present disclosure, User Equipment (UE) includes a processor and memory.

The memory is adapted to storing an instruction executable by the processor.

The processor is adapted to:
in response to determining that the UE is experiencing an overheating condition due to an overhigh radio link configuration, sending, to a base station, first signaling to request a cooling configuration, and starting a timer of a preset timing period;
detecting a temperature of the UE at expiration of the timer; and
performing an operation corresponding to a result of the detection.

According to a sixth aspect of embodiments of the present disclosure, a base station includes a processor and memory.

The memory is adapted to storing an instruction executable by the processor.

The processor is adapted to:
receiving first signaling sent by LTE to request a cooling configuration;
generating response signaling containing the cooling configuration based on the first signaling; and
sending the response signaling.

According to a seventh aspect of embodiments of the present disclosure, a non-transitory computer-readable storage medium has stored thereon a computer instruction that, when executed by a processor, causes the processor to perform:
in response to determining that User Equipment (UE) is experiencing an overheating condition due to an overhigh radio link configuration, sending, to a base station, first signaling to request a cooling configuration, and starting a timer of a preset timing period;
detecting a temperature of the UE at expiration of the timer; and
performing an operation corresponding to a result of the detection.

According to an eighth aspect of embodiments of the present disclosure, a non-transitory computer-readable storage medium has stored thereon a computer instruction that, when executed by a processor, causes the processor to perform:
receiving first signaling sent by User Equipment (UE) to request a cooling configuration;
generating response signaling containing the cooling configuration based on the first signaling; and
sending the response signaling.

The technical solution provided by embodiments of the present disclosure includes beneficial effects as follows.

When UE determines that an overheating condition is caused such as by an overhigh radio link configuration, the UE sends, to a base station, first signaling to request a cooling configuration, such that the overheated UE may lower the temperature per se by signaling the base station to request the cooling configuration without interrupting transmission of service data. Moreover, a timer of a preset timing period is started after the first signaling is sent. A temperature of the UE at expiration of the timer is detected. An operation corresponding to a result of the detection is performed, avoiding a burden of frequent signaling at an arbitrary time.

The above general description and elaboration below are but exemplary and explanatory, and do not limit the subject disclosure.

### BRIEF DESCRIPTION OF THE DRAWINGS

A drawing here is incorporated in the subject disclosure, constitutes part of the subject disclosure, illustrates embodiments according to the subject disclosure, and together with the subject disclosure, serves to explain the principle of the subject disclosure.
FIG. 1A is a flowchart of a UE overheating protection method according to an exemplary embodiment.
FIG. 1B is a diagram of a scene of a UE overheating protection method according to an exemplary embodiment.
FIG. 1C is a diagram of timing of a timer according to an exemplary embodiment.
FIG. 1D is a diagram of timing of a timer according to an exemplary embodiment.
FIG. 2 is a flowchart of a UE overheating protection method according to an exemplary embodiment.
FIG. 3 is a flowchart of a UE overheating protection method according to an exemplary embodiment.
FIG. 4 is a flowchart of a UE overheating protection method according to an exemplary embodiment.
FIG. 5 is a flowchart of implementing a UE overheating protection method by interaction between a base station and UE according to an exemplary embodiment.
FIG. 6 is a block diagram of a UE overheating protection device according to an exemplary embodiment.
FIG. 7 is a block diagram of a UE overheating protection device according to an exemplary embodiment.
FIG. 8 is a block diagram of a UE overheating protection device according to an exemplary embodiment.
FIG. 9 is a block diagram of a UE overheating protection device according to an exemplary embodiment.
FIG. 10 is a block diagram of an overheating protection device applying to UE according to an exemplary embodiment.
FIG. 11 is a block diagram of an overheating protection device applying to UE according to an exemplary embodiment.

### DETAILED DESCRIPTION

Exemplary embodiments (examples of which are illustrated in the accompanying drawings) are elaborated below. The following description refers to the accompanying drawings, in which identical or similar elements in two drawings are denoted by identical reference numerals unless indicated otherwise. Implementations set forth in the following exemplary embodiments do not represent all implementations in accordance with the subject disclosure. Rather, they are merely examples of the apparatus and method in accordance with certain aspects herein as recited in the accompanying claims.

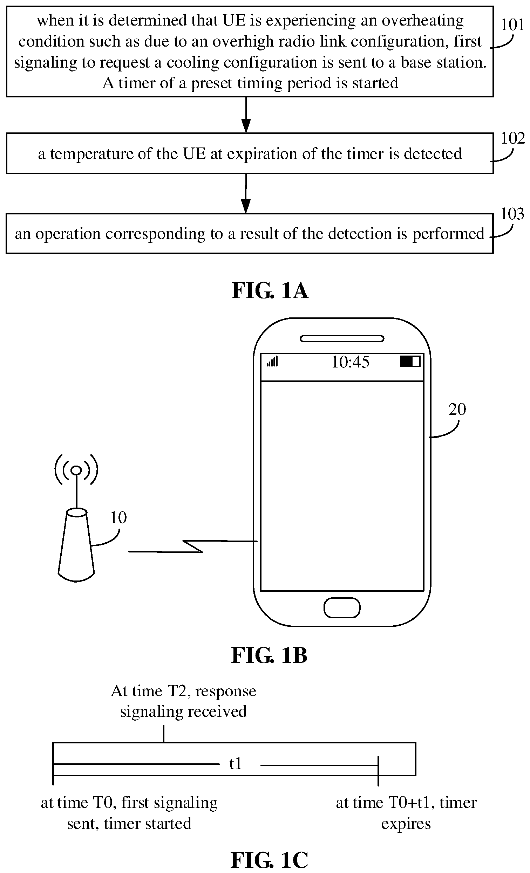

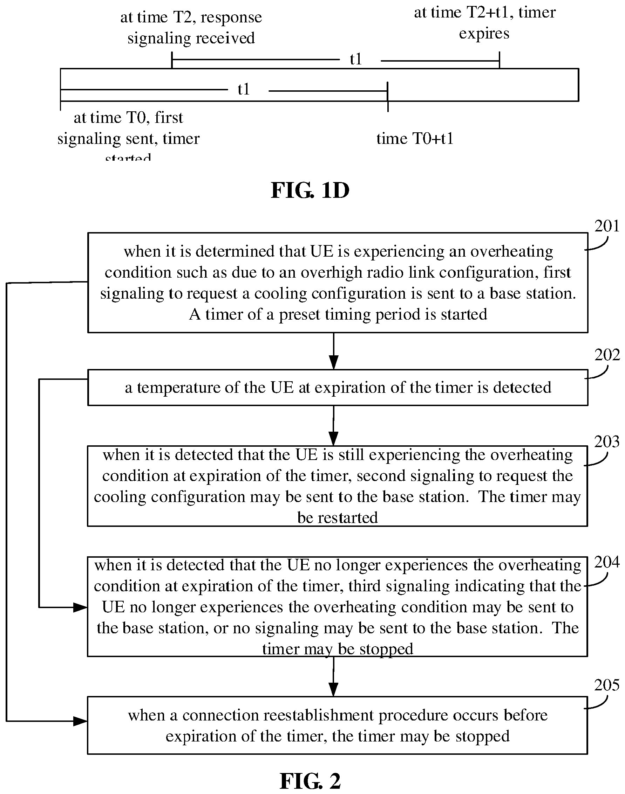

FIG. 1A is a flowchart of a UE overheating protection method according to an exemplary embodiment. FIG. 1B is a diagram of a scene of a UE overheating protection method according to an exemplary embodiment. FIG. 1C is a diagram of timing of a timer according to an exemplary embodiment. FIG. 1D is a diagram of timing of a timer according to an exemplary embodiment. The UE overheating protection method may apply to UE. As shown in FIG. 1A, the UE overheating protection method may include steps 101-103.

In step 101, when it is determined that UE is experiencing an overheating condition such as due to an overhigh radio link configuration, first signaling to request a cooling configuration is sent to a base station. A timer of a preset timing period is started.

In an embodiment, a timer of a preset timing period may be started while sending the first signaling. The timer may be started as soon as the first signaling is sent.

In an embodiment, a timer of a preset timing period may be set by the base station. The set timer may be indicated to the UE by Radio Resource Control (RRC) signaling, such as Otherconfig signaling in an RRC connection reconfiguration message.

In an embodiment, the first signaling includes assistance information that facilitates solving the overheating condition of the UE by the base station. The first signaling carries assistance information signaling the base station to solve the overheating condition of the UE. The assistance information includes information indicating lower-performance caused by the overheating condition. And/or, the assistance information includes a target radio link configuration to which the UE is to be adjusted. And/or, the assistance information includes temporary capability of the UE. Temporary capability of UE may be represented by a type of UE or a radio frequency parameter.

In an embodiment, it may be determined whether UE is experiencing an overheating condition by determining whether a temperature of the UE is greater than a preset temperature threshold for a set period of time. For example, when the temperature of UE is greater than 85 degrees for 5 minutes, it may be determined that the UE is experiencing an overheating condition. In an embodiment, the temperature of the UE may be a temperature of a surface of a battery of the UE. Or, the temperature of the UE may be a temperature of a surface of a Central Processing Unit (CPU). Or, the temperature of the UE may be a temperature of a front screen or a rear housing of the UE, etc.

In step 102, a temperature of the UE at expiration of the timer is detected.

In an embodiment, referring to FIG. 1C, the UE may send the first signaling at time T0. The timer may be started at time T0. The timing period of the timer may be t1. Then, the UE may detect the temperature of the UE at time T0+t1. The UE may receive, at time T2, response signaling that is fed back according to the first signaling by the base station and contains the cooling configuration. Time T2 may be time between time T0 and time T0+t1. No operation may be performed on the timer. The temperature of the UE at time T0+t1 may be detected.

In an embodiment, the timer may be reset if the response signaling is received before expiration of the timer. The response signaling may be fed back by the base station based on the first signaling. The response signaling may contain the cooling configuration. After the timer is reset, the temperature of the UE at expiration of the timer may be detected. Referring to FIG. 1D, the UE may send the first signaling at time T0. The timer may be started at time T0. The timing period of the timer may be t1. Then, the UE may detect the temperature of the UE at time T0+t1. The UE may receive, at time T2, response signaling that is fed back by the base station and contains the cooling configuration. Time T2 may be tiem between time T0 and time T0+t1. The timer may be reset, namely restarted, at time T2. The UE may detect the temperature of the UE at time T2+t1.

In an embodiment, if UE a connection reestablishment procedure occurs before expiration of the timer, the timer may be stopped.

In step 103, an operation corresponding to a result of the detection is performed.

In an embodiment, the result of the detection may indicate that the UE is still experiencing the overheating condition. The result of the detection may indicate that the UE no longer experiences the overheating condition.

In an embodiment, one may refer to the embodiment shown in FIG. 2 for an overheating protection operation performed based on the result of the detection, which will not be elaborated here.

An exemplary scene as shown in FIG. 1B may include a base station 10, UE 20 such as a smart phone, a tablet computer, etc. When it is determined that an overheating condition is caused by an overhigh radio link configuration, the UE 20 may send first signaling to the base station 10 to request a cooling configuration. Thus, the overheated UE 20 may lower temperature per se by signaling the base station 10 to request a cooling configuration. Moreover, a timer of a preset timing period may be set after the first signaling is sent. A temperature of the UE 20 at expiration of the timer may be detected. An operation corresponding to a result of the detection may be performed. For example, if it is detected that the UE is still experiencing the overheating condition, the signaling for requesting the cooling configuration may be sent to the base station 10 again. In addition, the timer may be restarted.

With step 101 to step 103, overheated UE may lower the temperature per se by signaling a base station to request a cooling configuration without interrupting transmission of service data. Moreover, a timer of a preset timing period is started after the first signaling is sent. A temperature of the UE at expiration of the timer is detected. An operation corresponding to a result of the detection is performed, avoiding a burden of frequent signaling at an arbitrary time.

In an embodiment, the temperature of the UE at expiration of the timer may be detected as follows.

The timer may be reset when the response signaling is received before expiration of the timer. The response signaling may be fed back by the base station based on the first signaling. The response signaling may contain the cooling configuration.

After the timer is reset, the temperature of the UE at expiration of the timer may be detected.

In an embodiment, the operation corresponding to the result of the detection may be performed as follows.

When it is detected that the UE is still experiencing the overheating condition at expiration of the timer, second signaling to request the cooling configuration may be sent to the base station. The timer may be restarted.

In an embodiment, the operation corresponding to the result of the detection may be performed as follows.

When it is detected that the UE no longer experiences the overheating condition at expiration of the timer, third signaling indicating that the UE no longer experiences the overheating condition may be sent to the base station. The timer may be stopped.

Alternatively, no signaling may be sent to the base station. The timer may be stopped.

In an embodiment, the UE overheating protection method may further include a step as follows.

When a connection reestablishment procedure occurs before expiration of the timer, the timer may be stopped.

Refer to embodiments below for a specific solution for UE overheating protection.

A technical solution according to embodiments of the present disclosure is described below with specific embodiments.

FIG. 2 is a flowchart of a UE overheating protection method according to an exemplary embodiment. Implementation of UE overheating protection using the method according to embodiments of the present disclosure is described exemplarily. As shown in FIG. 2, steps as follows may be included.

In step 201, when it is determined that UE is experiencing an overheating condition such as due to an overhigh radio link configuration, first signaling to request a cooling configuration is sent to a base station. A timer of a preset timing period is started. Step 202 or step 205 may then be performed.

In step 202, a temperature of the UE at expiration of the timer is detected.

In an embodiment, one may refer to description of step 101 and step 102 of the embodiment shown in FIG. 1A for description of step 201 and step 202, which is not repeated.

In step 203, when it is detected that the UE is still experiencing the overheating condition at expiration of the timer, second signaling to request the cooling configuration may be sent to the base station. The timer may be restarted.

In an embodiment, the first signaling and the second signaling may be identical. That is, assistance information that facilitates solving the overheating condition of the UE by the base station included in the first signaling may be identical to that included in the second signaling. The first signaling and the second signaling may differ. That is, assistance information that facilitates solving the overheating condition of the UE by the base station included in the first signaling may differ from that included in the second signaling.

In step 204, when it is detected that the UE no longer experiences the overheating condition at expiration of the timer, third signaling indicating that the UE no longer experiences the overheating condition may be sent to the base station, or no signaling may be sent to the base station. The timer may be stopped.

In an embodiment, when the result of the detection indicates that the UE no longer experiences the overheating condition, the third signaling adapted to indicate that the UE no longer experiences the overheating condition may be sent to the base station based on a system convention, or no signaling is sent to the base station.

In step 205, when a connection reestablishment procedure occurs before expiration of the timer, the timer may be stopped. The flow may then end.

In an embodiment, if the UE connection reestablishment procedure occurs before expiration of the timer due to a poor communication signal, etc., the timer may be stopped.

With step 201 to step 205, overheated UE may determine, based on a timer of a preset timing period, an interval for sending signaling to request a cooling configuration, avoiding a burden of frequent signaling to a base station at an arbitrary time, reducing utilization of a spectrum resource and a signaling burden on a network.

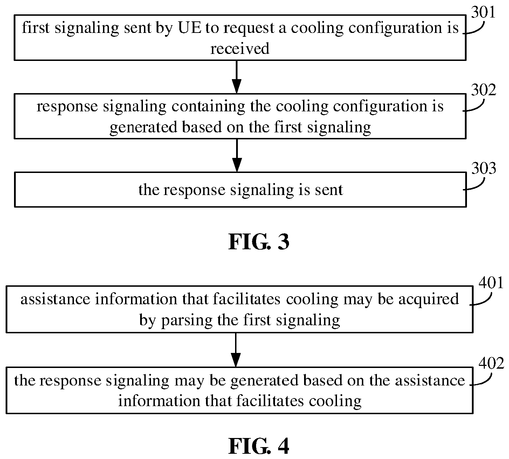

FIG. 3 is a flowchart of a UE overheating protection method according to an exemplary embodiment. The UE overheating protection method may apply to a base station. As shown in FIG. 3, the UE overheating protection method may include steps 301-303.

In step 301, first signaling sent by UE to request a cooling configuration is received.

In an embodiment, the first signaling includes assistance information that facilitates solving the overheating condition of the UE by the base station. The first signaling carries assistance information signaling the base station to solve the overheating condition of the UE. The assistance information includes information indicating lower-performance caused by the overheating condition. And/or, the assistance information includes a target radio link configuration to which the UE is to be adjusted. And/or, the assistance information includes temporary capability of the UE. Temporary capability of UE may be represented by a type of UE or a radio frequency parameter.

In step 302, response signaling containing the cooling configuration is generated based on the first signaling.

In an embodiment, the first signaling includes assistance information that facilitates solving the overheating condition of the UE by the base station. The first signaling carries assistance information signaling the base station to solve the overheating condition of the UE. The assistance information includes information indicating lower-performance caused by the overheating condition. And/or, the assistance information includes a target radio link configuration to which the UE is to be adjusted. And/or, the assistance information includes temporary capability of the UE. Temporary capability of UE may be represented by a type of UE or a radio frequency parameter.

In an embodiment, the response signaling may be an RRC connection reconfiguration message.

In an embodiment, the first signaling may include a target radio link configuration to which the UE is to be adjusted. The base station may generate response signaling directly based on the target radio link configuration to which the UE is to be adjusted.

In an embodiment, the first signaling includes temporary capability of the UE. The base station may determine the target radio link configuration to which the UE is to be adjusted according to the temporary capability of the UE. The temporary capability of the UE may be determined such as according to the type of the UE in the first signaling. The base station may then generate the response signaling.

In step 303, the response signaling is sent.

An exemplary scene as shown in FIG. 1B may include a base station 10, UE 20 such as a smart phone, a tablet computer, etc. When it is determined that an overheating condition is caused by an overhigh radio link configuration, UE 20 may send first signaling to the base station 10 to request a cooling configuration. Thus, the overheated UE 20 may lower temperature per se by signaling the base station 10 to request a cooling configuration. Moreover, a timer of a preset timing period may be set after the first signaling is sent. A temperature of the UE 20 at expiration of the timer may be detected. An operation corresponding to a result of the detection may be performed. For example, if it is detected that the UE is still experiencing the overheating condition, the base station 10 may be signaled again to request the cooling configuration. In addition, the timer may be restarted.

With step 301 to step 303, a base station may determine a target radio link configuration to which the UE is to be adjusted based on first signaling sent by the UE to request a cooling configuration. The UE is cooled by lowering the radio link configuration of the UE, avoiding interruption of transmission of service data in related art.

In an embodiment, response signaling containing the cooling configuration may be generated based on the first signaling as follows.

The assistance information that facilitates cooling may be acquired by parsing the first signaling.

The response signaling may be generated based on the assistance information that facilitates cooling.

Refer to specific embodiments below for a solution for UE overheating protection.

A technical solution according to embodiments of the present disclosure is described as follows.

FIG. 4 is a flowchart of a UE overheating protection method according to an exemplary embodiment. Generation of response signaling using the method according to embodiments of the present disclosure is described exemplarily. As shown in FIG. 4, steps as follows may be included.

In step 401, assistance information that facilitates cooling may be acquired by parsing the first signaling.

In an embodiment, the assistance information includes information indicating lower-performance caused by the overheating condition. The assistance information includes a target radio link configuration to which the UE is to be adjusted. The assistance information includes temporary capability of the UE. Temporary capability of UE may be represented by a type of UE or a radio frequency parameter.

In step 402, the response signaling may be generated based on the assistance information that facilitates cooling.

In an embodiment, the first signaling may include a target radio link configuration to which the UE is to be adjusted. The base station may generate response signaling directly based on the target radio link configuration to which the UE is to be adjusted.

In an embodiment, the first signaling includes temporary capability of the UE. The base station may determine the target radio link configuration to which the UE is to be adjusted according to the temporary capability of the UE. In an embodiment, the temporary capability of the UE may be determined such as according to the type of the UE in the first signaling. The base station may then generate the response signaling. The temporary capability of the UE may be represented by the type of UE. The base station may then determine the target radio link configuration to which the UE is to be adjusted according to the type of UE in the first signaling. In an embodiment, the temporary capability of the UE may be represented by the radio frequency parameter. The base station may then determine the temporary capability of the UE according to the radio frequency parameter in the first signaling.

In an embodiment, the base station may generate response signaling of RRC connection reconfiguration based on the determined target radio link configuration to which the UE is to be adjusted.

With step 401 to step 402, a base station may determine a target radio link configuration to which the UE is to be adjusted based on first signaling sent by the UE to request a cooling configuration. The UE is cooled by lowering the radio link configuration of the UE.

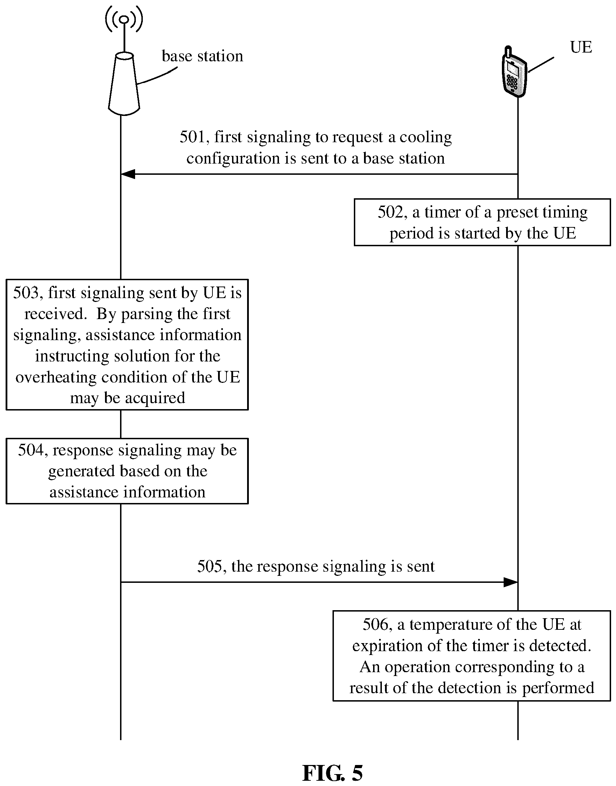

FIG. 5 is a flowchart of implementing a UE overheating protection method by interaction between a base station and UE according to an exemplary embodiment. Implementing UE overheating protection by interaction between a base station and UE according to embodiments of the present disclosure is described exemplarily. As shown in FIG. 5, steps as follows may be included.

In step 501, UE sends, to a base station, first signaling to request a cooling configuration when the UE is experiencing an overheating condition due to an overhigh radio link configuration.

In step 502, a timer of a preset timing period is started by the UE.

In an embodiment, a timer of a preset timing period may be started after the first signaling is sent. The timer may be started as soon as the first signaling is sent.

In step 503, the base station receives the first signaling sent by the UE. By parsing the first signaling, the base station may acquire assistance information that instructs a solution for the overheating condition of the UE.

In step 504, the base station may generate response signaling based on the assistance information.

In step 505, the base station sends the response signaling.

In step 506, a temperature of the UE at expiration of the timer is detected. An operation corresponding to a result of the detection is performed.

With step 501 to step 506, the overheated UE may lower the temperature per se by signaling a base station to request a cooling configuration without interrupting transmission of service data, avoiding a burden of frequent signaling at an arbitrary time by performing an overheating protection operation a preset period after first signaling is sent as determined using a timer.

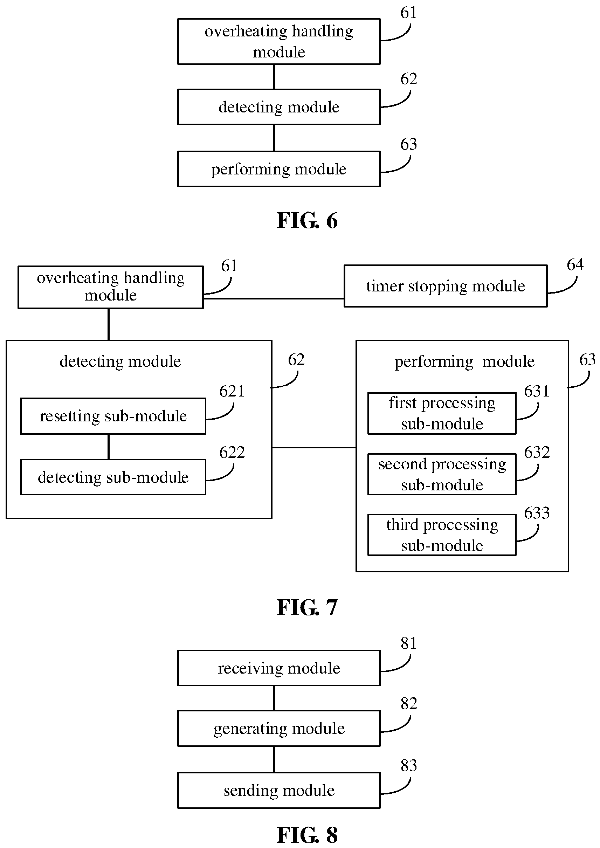

FIG. 6 is a block diagram of a UE overheating protection device according to an exemplary embodiment. The device applies to UE. As shown in FIG. 6, the UE overheating protection device includes an overheating handling module, a detecting module, and a performing module.

The overheating handling module 61 is adapted to, in response to determining that the UE is experiencing an overheating condition due to an overhigh radio link configuration, sending, to a base station, first signaling to request a cooling configuration, and starting a timer of a preset timing period.

The detecting module 62 is adapted to detecting a temperature of the UE at expiration of the timer.

The performing module 63 is adapted to performing an operation corresponding to a result of the detection.

FIG. 7 is a block diagram of a UE overheating protection device according to an exemplary embodiment. As shown in FIG. 7, based on the embodiment shown in FIG. 6, in an embodiment, the detecting module 62 may include a resetting sub-module and a detecting sub-module.

The resetting sub-module 621 may be adapted to resetting the timer in response to receiving, before expiration of the timer, response signaling that is fed back by the base station based on the first signaling and that contains the cooling configuration.

The detecting sub-module 622 may be adapted to, after the timer is reset, detecting the temperature of the UE at expiration of the timer.

In an embodiment, the performing module 63 may include a first processing sub-module.

The first processing sub-module 631 may be adapted to, in response to the result of the detection being that the UE is still experiencing the overheating condition at expiration of the timer, sending, to the base station, second signaling to request the cooling configuration, and restarting the timer.

In an embodiment, the performing module 63 may include a second processing sub-module or a third processing sub-module.

The second processing sub-module 632 may be adapted to, in response to the result of the detection being that the UE no longer experiences the overheating condition at expiration of the timer, sending, to the base station, third signaling indicating that the UE no longer experiences the overheating condition, and stopping the timer.

The third processing sub-module 633 may be adapted to sending no signaling to the base station, and stopping the timer.

In an embodiment, the device may further include a timer stopping module.

The timer stopping module 64 may be adapted to, in response to occurrence of a connection reestablishment procedure before expiration of the timer, stopping the timer.

FIG. 8 is a block diagram of a UE overheating protection device according to an exemplary embodiment. The device applies to a base station. As shown in FIG. 8, the UE overheating protection device includes a receiving module, a generating module, and a sending module.

The receiving module 81 is adapted to receiving first signaling sent by UE to request a cooling configuration.

The generating module 82 is adapted to generating response signaling containing the cooling configuration based on the first signaling received by the receiving module 81.

The sending module 83 is adapted to sending the response signaling generated by the generating module 82.

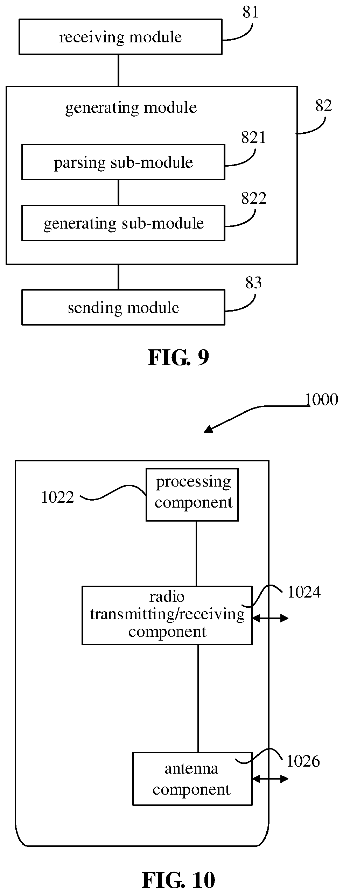

FIG. 9 is a block diagram of a UE overheating protection device according to an exemplary embodiment. As shown in FIG. 9, based on the embodiment shown in FIG. 8, in an embodiment, the generating module 82 may include a parsing sub-module and a generating sub-module.

The parsing sub-module 821 may be adapted to acquiring assistance information that facilitates cooling by parsing the first signaling.

The generating sub-module 822 may be adapted to generating the response signaling based on the assistance information that facilitates cooling.

Refer to an exemplary method herein for elaboration of a way a module of the device herein performs an operation, which is not repeated here.

FIG. 10 is a block diagram of an overheating protection device applying to UE according to an exemplary embodiment. The device 1000 may be provided as a base station. Referring to FIG. 10, the device 1000 includes a processing component 1022, a radio transmitting/receiving component 1024, an antenna component 1026, and a signal processing part dedicated to a radio interface. The processing component 1022 may further include one or more processors.

A processor of the processing component 1022 may be adapted to performing the UE overheating protection method.

A non-transitory computer-readable storage medium including instructions is provided. The instructions may be executed by the processing component 1022 of the device 1000 to implement the method. For example, the non-transitory computer-readable storage medium may be a Read-Only Memory (ROM), a Random Access Memory (RAM), a Compact Disc Read-Only Memory (CD-ROM), a magnetic tape, a floppy disk, optical data storage equipment, etc.

A non-transitory computer-readable storage medium has stored thereon instructions. When executed by a processor of a base station, the instructions cause the base station to perform the UE overheating protection method as disclosed in the second aspect, including:
receiving first signaling sent by User Equipment (UE) to request a cooling configuration;
generating response signaling containing the cooling configuration based on the first signaling; and
sending the response signaling.

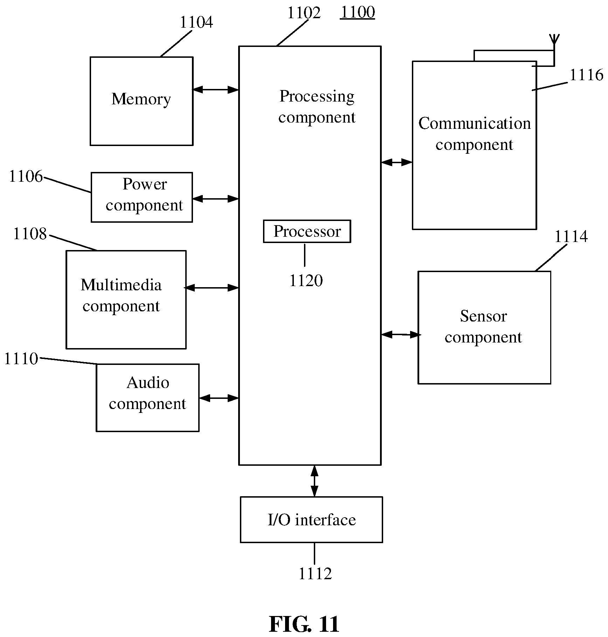

FIG. 11 is a block diagram of an overheating protection device applying to UE according to an exemplary embodiment. For example, the device 1100 may be first equipment, such as a smart phone.

Referring to FIG. 11, the device 1100 may include one or more of a processing component 1102, memory 1104, a power supply component 1106, a multimedia component 1108, an audio component 1110, an Input / Output (I/O) interface 1112, a sensor component 1114, and a communication component 1116.

The processing component 1102 may generally control an overall operation of the device 1100, such as operations associated with display, a telephone call, data communication, a camera operation, and a recording operation. The processing component 1102 may include one or more processors 1120 to execute instructions so as to complete all or some steps of the method. In addition, the processing component 1102 may include one or more modules to facilitate interaction between the processing component 1102 and other components. For example, the processing component 1102 may include a multimedia module to facilitate interaction between the multimedia component 1108 and the processing component 1102.

The memory 1104 may be adapted to storing various types of data to support the operation at the device 1100. Examples of such data may include instructions of any application or method adapted to operating on the device 1100, messages, pictures, and/or the like. The memory 1104 may be realized by any type of transitory or non-transitory storage equipment or combination thereof, such as Static Random Access Memory (SRAM), Electrically Erasable Programmable Read-Only Memory (EEPROM), Erasable Programmable Read-Only Memory (EPROM), Programmable Read-Only Memory (PROM), Read-Only Memory (ROM), magnetic memory, flash memory, a magnetic disk, or a compact disk.

The power supply component 1106 may supply electric power to various components of the device 1100. The power supply component 1106 may include a power management system, one or more power sources, and other components related to generating, managing and distributing electricity for the device 1100.

The multimedia component 1108 may include a screen providing an output interface between the apparatus 1100 and a user. The screen may include a Liquid Crystal Display (LCD) and a Touch Panel (TP). If the screen includes a TP, the screen may be realized as a touch screen to receive an input signal from a user. The TP may include one or more touch sensors for sensing touch, slide and gestures on the TP. The touch sensors not only may sense the boundary of a touch or slide move, but also detect the duration and pressure related to the touch or slide move. The multimedia component 1108 may include a front camera and/or a rear camera. When the equipment 1100 is in an operation mode such as a shooting mode or a video mode, the front camera and/or the rear camera may receive external multimedia data. Each of the front camera or the rear camera may be a fixed optical lens system or may have a focal length and be capable of optical zooming.

The audio component 1110 may be adapted to outputting and/or inputting an audio signal. For example, the audio component 1110 may include a microphone (MIC). When the device 1100 is in an operation mode such as a call mode, a recording mode, and a voice recognition mode, the MIC may be adapted to receiving an external audio signal. The received audio signal may be further stored in the memory 1104 or may be sent via the communication component 1116. The audio component 1110 may further include a loudspeaker adapted to outputting the audio signal.

The I/O interface 1112 may provide an interface between the processing component 1102 and a peripheral interface module. Such a peripheral interface module may be a keypad, a click wheel, a button, and/or the like. Such a button may include but is not limited to: a homepage button, a volume button, a start button, and a lock button.

The sensor component 1114 may include one or more sensors for assessing various states of the device 1100. For example, the sensor component 1114 may detect an on/off state of the device 1100 and relative positioning of components such as the display and the keypad of the device 1100. The sensor component 1114 may further detect a change in the position of the device 1100 or of a component of the device 1100, whether there is contact between the device 1100 and a user, the orientation or acceleration/deceleration of the device 1100, a change in the temperature of the device 1100. The sensor component 1114 may include a proximity sensor adapted to detecting existence of a nearby object without physical contact. The sensor component 1114 may further include an optical sensor such as a Complementary Metal-Oxide-Semiconductor (CMOS) or a Charge-Coupled-Device (CCD) image sensor used in an imaging application. The sensor component 1114 may further include an acceleration sensor, a gyroscope sensor, a magnetic sensor, a distance sensor, a pressure sensor, or a temperature sensor.

The communication component 1116 may be adapted to facilitating wired or wireless communication between the device 1100 and other equipment. The device 1100 may access a wireless network based on a communication standard such as Wi-Fi, 2G, 3G, or combination thereof. The communication component 1116 may broadcast related information or receive a broadcast signal from an external broadcast management system via a broadcast channel. The communication component 1116 may further include a Near Field Communication (NFC) module for short-range communication. For example, the NFC module may be based on technology such as Radio Frequency Identification (RFID), Infrared Data Association (IrDA), Ultra-Wideband (UWB) technology, Bluetooth (BT), etc.

The device 1100 may be realized by one or more electronic components such as an Application Specific Integrated Circuit (ASIC), a Digital Signal Processor (DSP), a Digital Signal Processing Device (DSPD), a Programmable Logic Device (PLD), a Field Programmable Gate Array (FPGA), a controller, a microcontroller, a microprocessor, etc., to implement the UE overheating protection method.

In an exemplary embodiment, a non-transitory computer-readable storage medium including instructions, such as memory 1104 including instructions, may be provided. The instructions may be executed by the processor 1120 of the device 1100 to implement the method. For example, the non-transitory computer-readable storage medium may be Read-Only Memory (ROM), Random Access Memory (RAM), Compact Disc Read-Only Memory (CD-ROM), a magnetic tape, a floppy disk, optical data storage equipment, and/or the like.

A non-transitory computer-readable storage medium has stored thereon instructions. When executed by a processor of a device, the instructions cause the device to perform the UE overheating protection method as disclosed in the first aspect, including:
in response to determining that UE is experiencing an overheating condition due to an overhigh radio link configuration, sending, to a base station, first signaling to request a cooling configuration, and starting a timer of a preset timing period;
detecting a temperature of the UE at expiration of the timer; and
performing an operation corresponding to a result of the detection.

Other embodiments of the present disclosure will be apparent to one skilled in the art after he/she has considered the subject disclosure and practiced the invention disclosed herein. The subject application is intended to cover any variation, use, or adaptation of the subject disclosure following the general principle of the subject disclosure and including such departures from the subject disclosure as come within known or customary practice in the art. The subject disclosure and its embodiments are intended to be exemplary only, with a true scope of the subject disclosure being indicated by the appended claims.

The subject disclosure is not limited to the exact construction that has been described above and illustrated in the accompanying drawings. Various modifications and changes can be made without departing from the scope of the subject disclosure. It is intended that the scope of the subject disclosure be limited only by the appended claims.

## Claims

1. A method for implementing User Equipment, UE, overheating protection, applying to UE (1100), the method comprising:
in response to determining that the UE (1100) is experiencing an overheating condition due to an overhigh radio link configuration, sending, to a base station (1000), first signaling to request a cooling configuration, and starting a timer of a preset timing period (101, 201, 501-502);
detecting a temperature of the UE (1100) at expiration of the timer (102, 202, 506); and
performing an operation corresponding to a result of the detection (103, 506),
wherein the first signaling comprises at least one of temporary capability of the UE (1100) or a target radio link configuration to which the UE (1100) is to be adjusted,
**characterized in that** the detecting a temperature of the UE (1100) at expiration of the timer comprises:
resetting the timer in response to receiving, before expiration of the timer, response signaling, wherein the response signaling is fed back by the base station (1000) based on the first signaling and contains the cooling configuration; and
after the timer is reset, detecting the temperature of the UE (1100) at expiration of the timer,
wherein the performing an operation corresponding to a result of the detection comprises:
in response to the result of the detection being that the UE (1100) is still experiencing the overheating condition at expiration of the timer, sending, to the base station (1000), second signaling to request the cooling configuration, and restarting the timer (203).

2. The method of claim 1, wherein the performing an operation corresponding to a result of the detection comprises:
in response to the result of the detection being that the UE (1100) no longer experiences the overheating condition at expiration of the timer, sending, to the base station (1000), third signaling indicating that the UE (1100) no longer experiences the overheating condition, and stopping the timer (204); or
sending no signaling to the base station (1000), and stopping the timer (204).

3. The method of claim 1, further comprising:
in response to occurrence of a connection reestablishment procedure before expiration of the timer, stopping the timer (205).

4. A method for implementing User Equipment, UE, overheating protection, comprising:
receiving first signaling sent by UE (1100) to request a cooling configuration (301);
generating response signaling containing the cooling configuration based on the first signaling (302); and
sending the response signaling (303, 505),
wherein the first signaling comprises at least one of temporary capability of the UE (1100) or a target radio link configuration to which the UE (1100) is to be adjusted,
**characterized in that** the generating response signaling containing the cooling configuration based on the first signaling comprises:
acquiring the at least one of the temporary capability of the UE (1100) or the target radio link configuration to which the UE (1100) is to be adjusted by parsing the first signaling (401); and
generating the response signaling based on the at least one of the temporary capability of the UE (1100) or the target radio link configuration to which the UE (1100) is to be adjusted (402, 504).

5. User Equipment, UE (1100), comprising a processor (1120) and memory (1104),
wherein the memory (1104) is adapted to storing an instruction executable by the processor (1120),
wherein the processor (1120) is adapted to:
in response to determining that the UE (1100) is experiencing an overheating condition due to an overhigh radio link configuration, sending, to a base station (1000), first signaling to request a cooling configuration, and starting a timer of a preset timing period;
detecting a temperature of the UE (1100) at expiration of the timer; and
performing an operation corresponding to a result of the detection,
wherein the first signaling comprises at least one of temporary capability of the UE (1100) or a target radio link configuration to which the UE (1100) is to be adjusted,
**characterized in that** the detecting a temperature of the UE (1100) at expiration of the timer comprises:
resetting the timer in response to receiving, before expiration of the timer, response signaling, wherein the response signaling is fed back by the base station (1000) based on the first signaling and contains the cooling configuration; and
after the timer is reset, detecting the temperature of the UE (1100) at expiration of the timer,
wherein the performing an operation corresponding to a result of the detection comprises:
in response to the result of the detection being that the UE (1100) is still experiencing the overheating condition at expiration of the timer, sending, to the base station (1000), second signaling to request the cooling configuration, and restarting the timer.

6. The UE (1100) of claim 5, wherein the performing an operation corresponding to a result of the detection comprises:
in response to the result of the detection being that the UE (1100) no longer experiences the overheating condition at expiration of the timer, sending, to the base station (1000), third signaling indicating that the UE (1100) no longer experiences the overheating condition, and stopping the timer; or
sending no signaling to the base station (1000), and stopping the timer.

7. The UE (1100) of claim 5, wherein the processor is further adapted to:
in response to occurrence of a connection reestablishment procedure before expiration of the timer, stopping the timer.

8. A base station (1000), comprising a processor and memory,
wherein the memory is adapted to storing an instruction executable by the processor,
wherein the processor is adapted to:
receiving first signaling sent by UE (1100) to request a cooling configuration;
generating response signaling containing the cooling configuration based on the first signaling; and
sending the response signaling,
wherein the first signaling comprises at least one of temporary capability of the UE (1100) or a target radio link configuration to which the UE (1100) is to be adjusted,
**characterized in that** the generating response signaling containing the cooling configuration based on the first signaling comprises:
acquiring the at least one of the temporary capability of the UE (1100) or the target radio link configuration to which the UE (1100) is to be adjusted by parsing the first signaling; and
generating the response signaling based on the at least one of the temporary capability of the UE (1100) or the target radio link configuration to which the UE (1100) is to be adjusted.

## Patentansprüche

1. Verfahren zum Implementieren von Überhitzungsschutz für ein Benutzergerät, User Equipment, UE, das am UE (1100) angewendet wird, wobei das Verfahren umfasst:
in Reaktion auf das Bestimmen, dass das UE (1100) einen Überhitzungszustand aufgrund einer überhöhten Funkverbindungskonfiguration erlebt, Senden einer ersten Signalisierung an eine Basisstation (1000), um eine Kühlkonfiguration anzufordern, und Starten eines Timers mit einem voreingestellten Zeitraum (101, 201, 501-502);
Erfassen einer Temperatur des UE (1100) bei Ablauf des Timers (102, 202, 506); und
Durchführen eines einem Ergebnis der Erfassung (103, 506) entsprechenden Vorgangs,
wobei die erste Signalisierung mindestens eines aus einer temporären Fähigkeit des UE (1100) oder einer Ziel-Funkverbindungskonfiguration umfasst, auf die das UE (1100) angepasst werden soll,
**dadurch gekennzeichnet, dass** das Erfassen einer Temperatur des UE (1100) bei Ablauf des Timers umfasst:
Zurücksetzen des Timers in Reaktion auf den Empfang einer Antwortsignalisierung vor Ablauf des Timers, wobei die Antwortsignalisierung von der Basisstation (1000) auf Basis der ersten Signalisierung zurückgegeben wird und die Kühlkonfiguration enthält; und
nachdem der Timer zurückgesetzt wurde, Erfassen der Temperatur des UE (1100) bei Ablauf des Timers,
wobei das Durchführen eines einem Ergebnis der Erfassung entsprechenden Vorgangs umfasst:
in Reaktion darauf, dass das Ergebnis der Erfassung lautet, dass das UE (1100) bei Ablauf des Timers immer noch den Überhitzungszustand erlebt, Senden einer zweiten Signalisierung an die Basisstation (1000), um die Kühlkonfiguration anzufordern, und Neustarten des Timers (203).

2. Verfahren nach Anspruch 1, wobei das Durchführen eines einem Ergebnis der Erfassung entsprechenden Vorgangs umfasst:
in Reaktion darauf, dass das Ergebnis der Erfassung lautet, dass das UE (1100) bei Ablauf des Timers den Überhitzungszustand nicht mehr erlebt, Senden einer dritten Signalisierung an die Basisstation (1000), die anzeigt, dass das UE (1100) den Überhitzungszustand nicht mehr erlebt, und Stoppen des Timers (204); oder
Senden keiner Signalisierung an die Basisstation (1000), und Stoppen des Timers (204).

3. Verfahren nach Anspruch 1, weiter umfassend:
in Reaktion auf das Auftreten einer Verbindungswiederaufbauprozedur vor Ablauf des Timers, Stoppen des Timers (205).

4. Verfahren zum Implementieren von Überhitzungsschutz für ein Benutzergerät, UE, umfassend:
Empfangen einer ersten Signalisierung, die vom UE (1100) gesendet wird, um eine Kühlkonfiguration anzufordern (301);
Erzeugen einer Antwortsignalisierung, die die Kühlkonfiguration enthält, auf Basis der ersten Signalisierung (302); und
Senden der Antwortsignalisierung (303, 505),
wobei die erste Signalisierung mindestens eines aus einer temporären Fähigkeit des UE (1100) oder einer Ziel-Funkverbindungskonfiguration umfasst, auf die das UE (1100) angepasst werden soll,
**dadurch gekennzeichnet, dass** das Erzeugen einer Antwortsignalisierung, die die Kühlkonfiguration enthält, auf Basis der ersten Signalisierung umfasst:
Erhalten des mindestens einen aus der temporären Fähigkeit des UE (1100) oder der Ziel-Funkverbindungskonfiguration, auf die das UE (1100) angepasst werden soll, durch Parsen der ersten Signalisierung (401); und
Erzeugen der Antwortsignalisierung auf Basis des mindestens einen aus einer temporären Fähigkeit des UE (1100) oder der Ziel-Funkverbindungskonfiguration, auf die das UE (1100) angepasst werden soll (402, 504).

5. Benutzergerät, UE (1100), das einen Prozessor (1120) und Speicher (1104) umfasst,
wobei der Speicher (1104) geeignet ist, eine Anweisung zu speichern, die von dem Prozessor (1120) ausgeführt werden kann,
wobei der Prozessor (1120) geeignet ist:
in Reaktion auf das Bestimmen, dass das UE (1100) einen Überhitzungszustand aufgrund einer überhöhten Funkverbindungskonfiguration erlebt, eine erste Signalisierung an eine Basisstation (1000) zu senden, um eine Kühlkonfiguration anzufordern, und einen Timer mit einem voreingestellten Zeitraum zu starten;
eine Temperatur des UE (1100) bei Ablauf des Timers zu erfassen; und
einem Ergebnis der Erfassung entsprechenden Vorgang durchzuführen,
wobei die erste Signalisierung mindestens eines aus einer temporären Fähigkeit des UE (1100) oder einer Ziel-Funkverbindungskonfiguration umfasst, auf die das UE (1100) angepasst werden soll,
**dadurch gekennzeichnet, dass** das Erfassen einer Temperatur des UE (1100) bei Ablauf des Timers umfasst:
Zurücksetzen des Timers in Reaktion auf den Empfang einer Antwortsignalisierung vor Ablauf des Timers, wobei die Antwortsignalisierung von der Basisstation (1000) auf Basis der ersten Signalisierung zurückgegeben wird und die Kühlkonfiguration enthält; und
nachdem der Timer zurückgesetzt wurde, Erfassen der Temperatur des UE (1100) bei Ablauf des Timers,
wobei das Durchführen eines einem Ergebnis der Erfassung entsprechenden Vorgangs umfasst:
in Reaktion darauf, dass das Ergebnis der Erfassung lautet, dass das UE (1100) bei Ablauf des Timers immer noch den Überhitzungszustand erlebt, Senden einer zweiten Signalisierung an die Basisstation (1000), um die Kühlkonfiguration anzufordern, und Neustarten des Timers.

6. UE (1100) nach Anspruch 5, wobei das Durchführen eines einem Ergebnis der Erfassung entsprechenden Vorgangs umfasst:
in Reaktion darauf, dass das Ergebnis der Erfassung lautet, dass das UE (1100) bei Ablauf des Timers den Überhitzungszustand nicht mehr erlebt, Senden einer dritten Signalisierung an die Basisstation (1000), die anzeigt, dass das UE (1100) den Überhitzungszustand nicht mehr erlebt, und Stoppen des Timers; oder
Senden keiner Signalisierung an die Basisstation (1000), und Stoppen des Timers.

7. UE (1100) nach Anspruch 5, wobei der Prozessor weiter geeignet ist:
in Reaktion auf das Auftreten einer Verbindungswiederaufbauprozedur vor Ablauf des Timers, den Timer zu stoppen.

8. Basisstation (1000), die einen Prozessor und Speicher umfasst,
wobei der Speicher geeignet ist, eine Anweisung zu speichern, die von dem Prozessor ausgeführt werden kann,
wobei der Prozessor geeignet ist:
eine erste Signalisierung zu empfangen, die vom UE (1100) gesendet wird, um eine Kühlkonfiguration anzufordern;
eine Antwortsignalisierung zu erzeugen, die die Kühlkonfiguration enthält, auf Basis der ersten Signalisierung; und
die Antwortsignalisierung zu senden,
wobei die erste Signalisierung mindestens eines aus einer temporären Fähigkeit des UE (1100) oder einer Ziel-Funkverbindungskonfiguration umfasst, auf die das UE (1100) angepasst werden soll,
**dadurch gekennzeichnet, dass** das Erzeugen einer Antwortsignalisierung, die die Kühlkonfiguration enthält, auf Basis der ersten Signalisierung umfasst:
Erhalten des mindestens einen aus der temporären Fähigkeit des UE (1100) oder der Ziel-Funkverbindungskonfiguration, auf die das UE (1100) angepasst werden soll, durch Parsen der ersten Signalisierung; und
Erzeugen der Antwortsignalisierung auf Basis des mindestens einen aus der temporären Fähigkeit des UE (1100) oder der Ziel-Funkverbindungskonfiguration, auf die das UE (1100) angepasst werden soll.

## Revendications

1. Procédé de mise en oeuvre d'une protection contre la surchauffe d'un équipement utilisateur, UE, s'appliquant à un UE (1100), le procédé comprenant :
en réponse à la détermination que l'UE (1100) est dans un état de surchauffe en raison d'une configuration de liaison radio trop élevée, un envoi, à une station de base (1000), d'une première signalisation pour demander une configuration de refroidissement, et un démarrage d'un temporisateur d'une période de temporisation prédéfinie (101, 201, 501-502) ;
une détection d'une température de l'UE (1100) à l'expiration du temporisateur (102, 202, 506) ; et
une réalisation d'une opération correspondant à un résultat de la détection (103, 506),
dans lequel la première signalisation comprend au moins une d'une capacité temporaire de l'UE (1100) ou une configuration de liaison radio cible sur laquelle l'UE (1100) doit être réglé,
**caractérisé en ce que** la détection d'une température de l'UE (1100) à l'expiration du temporisateur comprend :
une réinitialisation du temporisateur en réponse à une réception, avant l'expiration du temporisateur, d'une signalisation de réponse, dans lequel la signalisation de réponse est retournée par la station de base (1000) sur la base de la première signalisation et contient la configuration de refroidissement ; et
après que le temporisateur a été réinitialisé, une détection de la température de l'UE (1100) à l'expiration du temporisateur,
dans lequel la réalisation d'une opération correspondant à un résultat de la détection comprend :
en réponse au résultat de la détection qui est que l'UE (1100) est toujours dans l'état de surchauffe à l'expiration du temporisateur, un envoi, à la station de base (1000), d'une deuxième signalisation pour demander la configuration de refroidissement, et un redémarrage du temporisateur (203).

2. Procédé selon la revendication 1, dans lequel la réalisation d'une opération correspondant à un résultat de la détection comprend :
en réponse au résultat de la détection qui est que l'UE (1100) n'est plus dans l'état de surchauffe à l'expiration du temporisateur, un envoi, à la station de base (1000), d'une troisième signalisation indiquant que l'UE (1100) n'est plus dans l'état de surchauffe, et un arrêt du temporisateur (204) ; ou
un envoi d'aucune signalisation à la station de base (1000), et un arrêt du temporisateur (204).

3. Procédé selon la revendication 1, comprenant en outre :
en réponse à la survenue d'une procédure de rétablissement de connexion avant l'expiration du temporisateur, un arrêt du temporisateur (205).

4. Procédé de mise en oeuvre d'une protection contre la surchauffe d'un équipement utilisateur, UE, comprenant :
une réception d'une première signalisation envoyée par un UE (1100) pour demander une configuration de refroidissement (301) ;
une génération d'une signalisation de réponse contenant la configuration de refroidissement sur la base de la première signalisation (302) ; et
un envoi de la signalisation de réponse (303, 505),
dans lequel la première signalisation comprend au moins une d'une capacité temporaire de l'UE (1100) ou une configuration de liaison radio cible sur laquelle l'UE (1100) doit être réglé,
**caractérisé en ce que** la génération d'une signalisation de réponse contenant la configuration de refroidissement sur la base de la première signalisation comprend :
une acquisition de la au moins une de la capacité temporaire de l'UE (1100) ou la configuration de liaison radio cible sur laquelle l'UE (1100) doit être réglé en analysant la première signalisation (401) ; et
une génération de la signalisation de réponse sur la base de la au moins une de la capacité temporaire de l'UE (1100) ou la configuration de liaison radio cible sur laquelle l'UE (1100) doit être réglé (402, 504).

5. Équipement utilisateur, UE (1100), comprenant un processeur (1120) et une mémoire (1104),
dans lequel la mémoire (1104) est adaptée pour stocker une instruction exécutable par le processeur (1120),
dans lequel le processeur (1120) est adapté pour :
en réponse à la détermination que l'UE (1100) est dans un état de surchauffe en raison d'une configuration de liaison radio trop élevée, envoyer, à une station de base (1000), une première signalisation pour demander une configuration de refroidissement, et démarrer un temporisateur d'une période de temporisation prédéfinie ;
détecter une température de l'UE (1100) à l'expiration du temporisateur ; et
réaliser une opération correspondant à un résultat de la détection,
dans lequel la première signalisation comprend au moins une d'une capacité temporaire de l'UE (1100) ou une configuration de liaison radio cible sur laquelle l'UE (1100) doit être réglé,
**caractérisé en ce que** la détection d'une température de l'UE (1100) à l'expiration du temporisateur comprend :
une réinitialisation du temporisateur en réponse à une réception, avant l'expiration du temporisateur, d'une signalisation de réponse, dans lequel la signalisation de réponse est retournée par la station de base (1000) sur la base de la première signalisation et contient la configuration de refroidissement ; et
après que le temporisateur a été réinitialisé, une détection de la température de l'UE (1100) à l'expiration du temporisateur,
dans lequel la réalisation d'une opération correspondant à un résultat de la détection comprend :
en réponse au résultat de la détection qui est que l'UE (1100) est toujours dans l'état de surchauffe à l'expiration du temporisateur, un envoi, à la station de base (1000), d'une deuxième signalisation pour demander la configuration de refroidissement, et un redémarrage du temporisateur.

6. UE (1100) selon la revendication 5, dans lequel la réalisation d'une opération correspondant à un résultat de la détection comprend :
en réponse au résultat de la détection qui est que l'UE (1100) n'est plus dans l'état de surchauffe à l'expiration du temporisateur, un envoi, à la station de base (1000), d'une troisième signalisation indiquant que l'UE (1100) n'est plus dans l'état de surchauffe, et un arrêt du temporisateur ; ou
un envoi d'aucune signalisation à la station de base (1000), et un arrêt du temporisateur.

7. UE (1100) selon la revendication 5, dans lequel le processeur est en outre adapté pour :
en réponse à la survenue d'une procédure de rétablissement de connexion avant l'expiration du temporisateur, arrêter le temporisateur.

8. Station de base (1000), comprenant un processeur et une mémoire,
dans laquelle la mémoire est adaptée pour stocker une instruction exécutable par le processeur,
dans laquelle le processeur est adapté pour :
recevoir une première signalisation envoyée par un UE (1100) pour demander une configuration de refroidissement ;
générer une signalisation de réponse contenant la configuration de refroidissement sur la base de la première signalisation ; et
envoyer la signalisation de réponse,
dans laquelle la première signalisation comprend au moins une d'une capacité temporaire de l'UE (1100) ou une configuration de liaison radio cible sur laquelle l'UE (1100) doit être réglé,
**caractérisée en ce que** la génération d'une signalisation de réponse contenant la configuration de refroidissement sur la base de la première signalisation comprend :
une acquisition de la au moins une de la capacité temporaire de l'UE (1100) ou la configuration de liaison radio cible sur laquelle l'UE (1100) doit être réglé en analysant la première signalisation ; et
une génération de la signalisation de réponse sur la base de la au moins une de la capacité temporaire de l'UE (1100) ou la configuration de liaison radio cible sur laquelle l'UE (1100) doit être réglé.
